# EUROPEAN PATENT APPLICATION

(11) **EP 1 734 625 A1**
(43) Date of publication of application: **20.12.2006**
(21) Application number: 06011769.4
(22) Date of filing: 07.06.2006
(51) Int. Cl.: H01S 5/22, H01L 33/00, H01S 5/343, H01S 5/183

(54) **Single epitaxial lateral overgrowth transverse p-n junction nitride semiconductor laser**

(30) Priority: 15.06.2005 US 154010
(71) Applicant: Avago Technologies ECBU IP (Singapore) Pte. Ltd., Singapore 768923 (SG)
(72) Inventor: Bour, David P., Cupertino CA 95014 (US); Corzine, Scott W., Sunnyvale CA 94087 (US)
(74) Representative: Schoppe, Fritz

(57) **Abstract**

A vertical quantum well nitride laser can be fabricated by ELOG (epitaxial lateral overgrowth), with the vertical quantum wells created by deposition over the vertical a-face of the laterally growing edges and forming the transverse junction in a single ELOG-MOCVD (metal organic chemical vapor deposition) growth step. Vertical quantum wells may be used for both GaN vertical cavity surface emitting lasers (VCSELs) and GaN edge emitting lasers.

## Description

### Background

GaInN quantum well structures are used in GaN based LEDs and lasers. Typical GaN based LED and laser structures have quantum well structures oriented parallel to the substrate that for edge emitters limit the area available for the p-contact and for VCSEL structures typically limit the resonant cavity size thereby limiting the VCSEL amplification.

### Summary of the Invention

A vertical quantum well nitride laser can be fabricated by ELOG (epitaxial lateral overgrowth), with the vertical quantum wells created by deposition over the vertical a-face of the laterally growing edges and forming the transverse junction in a single ELOG-MOCVD (metal organic chemical vapor deposition) growth step. The vertical quantum wells may be grown from the vertical a - face in which case the quantum wells are [11 -2 0] oriented or the vertical quantum wells may be grown from a vertical c-face in which case the quantum wells are [0 0 0 1] oriented. Vertical quantum wells may be used for both GaN vertical cavity surface emitting lasers (VCSELs) and GaN edge emitting lasers.

### Brief Description of the Drawings

FIGs. 1a-1e show steps for making a VCSEL in accordance with the invention.
FIG. I f shows a top view of an embodiment in accordance with the invention.
FIGs. 2a-b show making a VCSEL in accordance with the invention.
FIG. 2c shows a top view of an embodiment in accordance with the invention.
FIG. 3 shows an embodiment of an edge emitting laser in accordance with the invention.
FIG. 4 shows an embodiment of an edge emitting laser in accordance with the invention.

### Detailed Description

For GaN, strained quantum well structures are based on the wurtzite crystal structure. For example, under appropriate epitaxial lateral overgrowth (ELOG) conditions the vertical facet obtained is the a-face or (1 1 -2 0) as described by K. Hiramatsu et al. in Journal of Crystal Growth 221, 316-326, 2000 and incorporated by reference. Performing ELOG at a reactor pressure of about 800 Torr and a temperature of about 1000 °C can provide GaN vertical facets of (1 1 -2 0) when the horizontal facets are aligned along the c-face or (0 0 0 1). Alternatively, one may perform ELOG resulting in GaN films aligned with an a-face or (1 1 -2 0) so that the GaN vertical facets are (0 0 0 1). Typical growth temperatures are about 1100 °C with a V/III ratio, for example, ammonia to gallium, of about 1300. ELOG aligned with (1 1 -2 0) is described by Craven et al. in Applied Physics Letters 81,7, 1201-1203, 2002 and Haskell et al. in Applied Physics Letters 83, 4, 644-646, 2003, incorporated herein by reference.

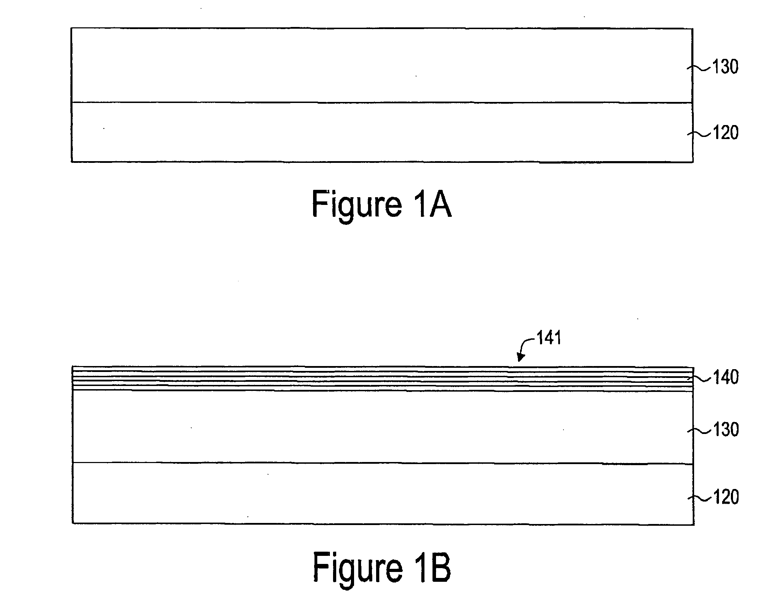

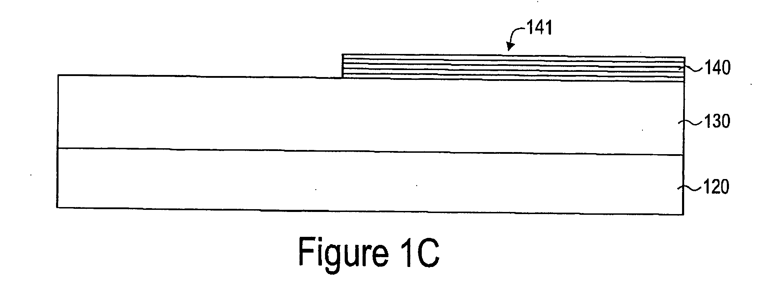

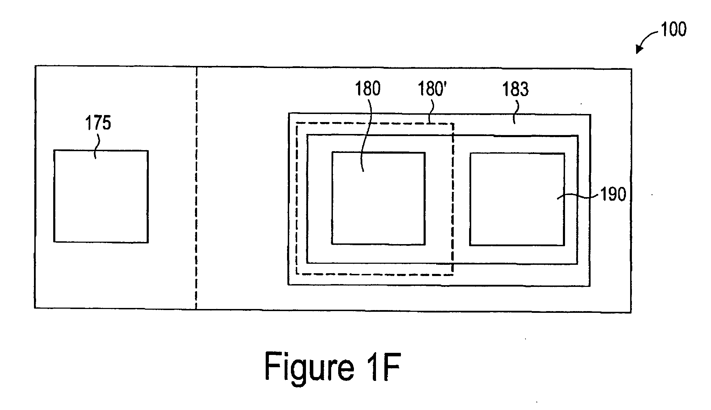

A vertical quantum well nitride laser can be fabricated by ELOG. Vertical quantum wells are created by growth over the vertical a-face of the laterally growing edges of the ELOG or by growth over the vertical c-face of the laterally growing edges of the ELOG depending on whether the planar GaN film is along the c-plane or along the a-plane, respectively. FIG. 1a shows an embodiment in accordance with the invention. In FIG. 1a, optional n-type GaN buffer layer 130 is grown over Al₂O₃ substrate 120 followed by deposition of distributed Bragg reflector (DBR) 140 over n-type GaN layer 130 as shown in FIG. 1b. However, DBR 140 may be grown directly on Al₂O₃ substrate 120 instead. Note that patterning of DBR 140 requires removal from the MOCVD reactor. DBR 140 must have a dielectric top surface 141, typically an oxide, to function as an ELOG mask. Possible materials for DBR 140 include alternating AlGaN/GaN layers capped with dielectric top surface 141, for example, SiO₂, having a typical thickness of about 1000 angstrom to avoid the existence of "pin holes" to the underlying nitride containing layer. Other possible materials for DBR 140 include alternating oxide layers of SiO₂/HfO₂, TiO₂/ SiO₂ or ZrO₂/SiO₂ which inherently provide dielectric top surface 141. After deposition of DBR 140, DBR 140 is patterned with photoresist and a portion of DBR is etched away using reactive ion etching (RIE), chemically assisted ion beam etching (CAIBE) or inductively coupled plasma etching (ICP) as shown in FIG. 1c.

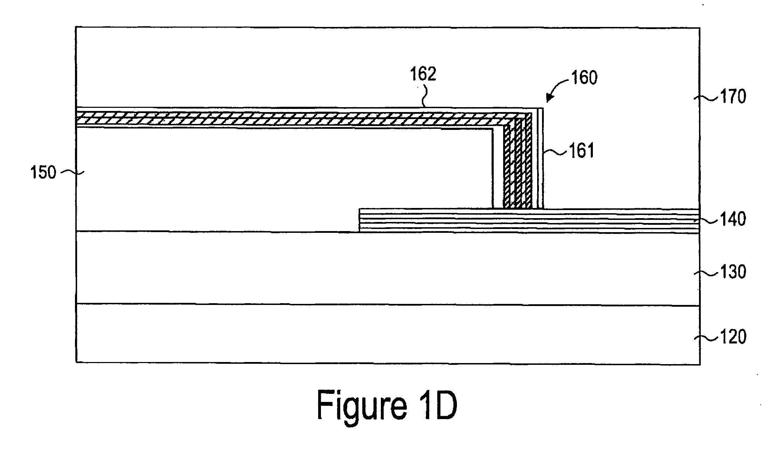

FIG. 1d shows ELOG growth of n-type AlGaN/GaN region 150, InGaN/InGaN multiple quantum well region 160 and p-type AIGaN region 170. Note that vertical growth does not occur on dielectric top surface 141, rather, dielectric top surface 141 is laterally overgrown. When ELOG growth of n-type AlGaN/GaN region 150 occurs over DBR 140, the laterally growing deposition fronts are smooth. Vertical sidewalls as shown in FIG. 1d or angled sidewalls may be obtained, depending on growth conditions. When n-type AlGaN/GaN region 150 has grown far enough over DBR 140 such that the crystal face sidewalls have developed, the ELOG growth conditions are modified by lowering the reactor temperature to about 700 °C to about 800 °C to allow the incorporation of In for growing InGaN/InGaN multiple quantum well region 160. Note the sample remains in the MOVCD reactor throughout the ELOG growth allowing a single ELOG-MOVCD growth step. Hence, regrowth is avoided. The growth time for n-type AlGaN/GaN region 150 serves as a control parameter for adjusting the length (vertical extent) of InGaN/InGaN multiple quantum well region 160.

With reference to FIG. 1d, note that part of multiple quantum well region 160 is vertical and part of multiple quantum well region 160 is horizontal. Horizontal part 162 of multiple quantum well region 160 is grown over the c-face of n-type AIGaN/GaN region 150, in accordance with an embodiment of the invention, and horizontal part 162 has thinner layers and lower indium content compared to vertical part 161 of multiple quantum well region 160. This is due to the high lateral to vertical growth rate enhancement in ELOG. The turn-on voltage is typically several tenths of a volt higher for the p-n junction of horizontal part 162 compared to the transverse p-n junction of vertical part 161. Hence, the injection current is typical ly well-confined to vertical part 161 of multiple quantum well region 160.

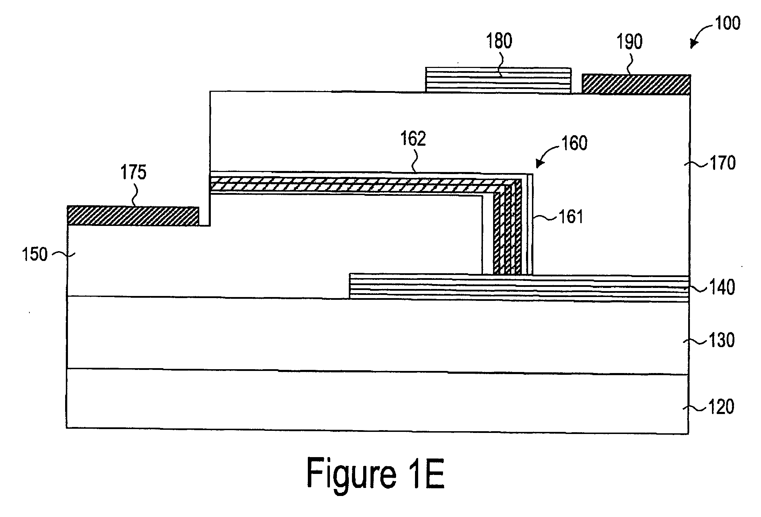

After growth of InGaN/InGaN multiple quantum well region 160, growth of p-type AIGaN/GaN region 170 occurs by again modifying the ELOG growth conditions by increasing the temperature to about 800 °C to about 1100 °C. This modification of the growth conditions is dictated by the need for p-type doping. ELOG growth of p-type AlGaN/GaN region 170 is maintained until about 0.5 µm to about 10 µm of lateral growth from vertical part 161 of multiple quantum well region 160 has occurred to provide a cladding layer. Note that 0.5 µm is the minimum thickness for a cladding layer. DBR 180 is then deposited over p-type AlGaN/GaN region 170. Possible materials for DBR 180 include alternating oxide layers of SiO₂/HfO₂ or ZrO₂/SiO₂. After DBR 180 is deposited it is patterned with photoresist and the exposed portions are etched away to yield DBR 180 as shown in FIG. 1e. To allow deposition of n-type contact 175, typically Ti-Au, a portion of region 170, a portion of horizontal part 162 of multiple quantum well region 160 and a portion of region 150 are etched away using, for example, chemically assisted ion beam etching (CAIBE) discussed in more detail below. Additionally, trench 183 is typically also etched to a depth near or into multiple quantum well region 160 using CAIBE to provide carrier and optical confinement as shown in top view in FIG. If by enclosing DBR 180 and p type-contact 190 to force current through the current aperture region of VCSEL structure 100. Note that DBR 180 may partially overlap trench 183 as shown by the dotted outline of DBR 180'. Then n-type contact 175 and p-type contact 190 are deposited as shown in FIG. 1e resulting in VCSEL structure 100. VCSEL structure 100 allows creation of VCSELs with threshold gain comparable to edge emitters.

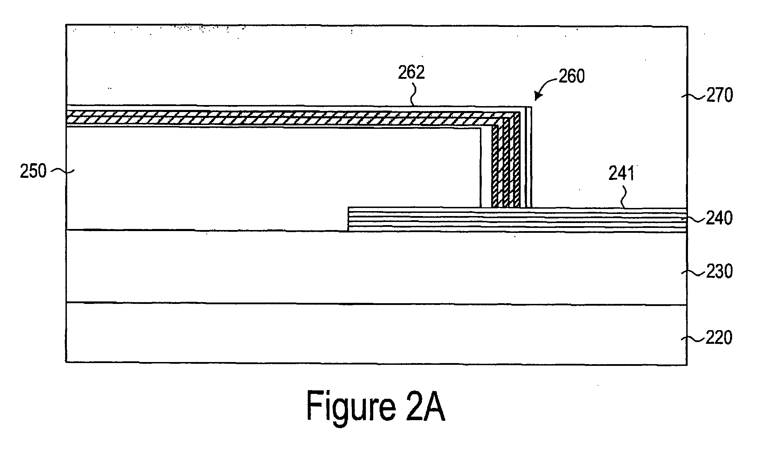

FIG. 2a shows an embodiment in accordance with the invention which may be used if parasitic effects are a concern. Differences between VCSEL structure 100 and VCSEL structure 200 involve the removal of horizontal part 262 of multiple quantum well region 260 (see FIG. 2a). FIG. 2a is similar to FIG. 1d. Optional n-type GaN layer 230 is grown over Al₂O₃ substrate 220 followed by deposition of distributed Bragg reflector (DBR) 240 over n-typeGaN layer 230. However, DBR 240 may be grown directly on Al₂O₃ substrate 220 instead. DBR 240 typically has a dielectric top surface 241, typically an oxide, to function as an ELOG mask. Possible materials for DBR 240 include alternating AIGaN/GaN layers capped with dielectric top surface 241, for example, SiO₂, having a typical thickness of about 1000 angstrom to avoid the existence of "pin holes" to the underlying nitride containing layer. Other possible materials for DBR 240 include alternating oxide layers of SiO₂/HfO₂, TiO₂/SiO₂ or ZrO₂/SiO₂ which inherently provide dielectric top surface 241. After deposition of DBR 240, DBR 240 is patterned with photoresist and a portion of DBR is etched away using RIE, CAIBE or ICP to allow ELOG growth of n-type AIGaN/GaN region 250. Note that vertical growth does not occur over dielectric top surface 241, growth is lateral. When ELOG growth of n-type AlGaN/GaN layer 250 occurs over DBR 140, the laterally growing deposition fronts are smooth and vertical. When n-type AlGaN/GaN layer 250 has grown sufficiently over DBR 240 such that the crystal face sidewalls have developed, ELOG growth conditions are modified by lowering the temperature of the reactor to allow incorporation of In to grow lnGaN/InGaN multiple quantum well region 260. Note the sample remains in the MOVCD reactor throughout the ELOG growth allowing a single ELOG-MOVCD growth step. Hence, regrowth is avoided.

After growth of InGaN/InGaN multiple quantum well region 260, growth of p-type AIGaN/GaN region 270 occurs by again modifying the ELOG growth conditions by increasing the reactor temperature. Note the sample remains in the MOVCD reactor throughout the ELOG growth. ELOG growth of p-type AlGaN/GaN region 270 is maintained until about 0.5 to about 10 µm of lateral growth from InGaN/InGaN multiple quantum well region 260 to form a cladding layer has occurred resulting in the structure shown in FIG. 2a.

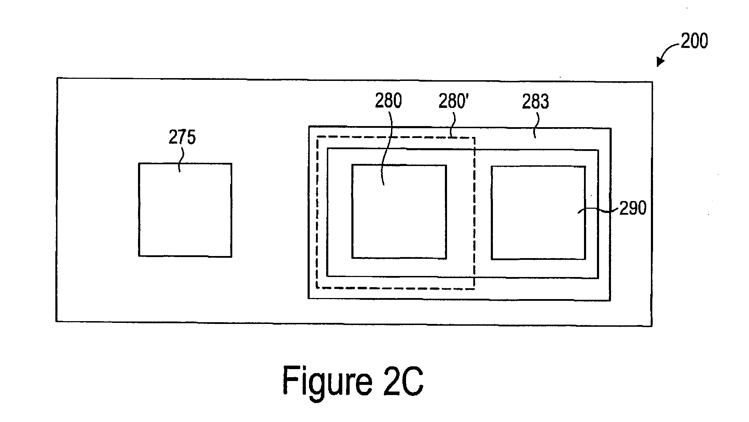

Overlying portion of region 270 and horizontal part 262 of multiple quantum well region 260 in FIG. 2a may be removed to expose region 250 by using chemically assisted ion beam etching (CAIBE) or other suitable etching method. Additionally, trench 283 is typically also etched using CAIBE to provide carrier and optical confinement as shown in top view in FIG. 2c by enclosing DBR 280 and p type-contact 290 to force current through the current aperture region of VCSEL structure 200. Note that DBR 280 may partially overlap trench 283 as shown by the dotted outline of DBR 280'. CAIBE uses a highly dense and uniform ion beam, typically Ar⁺, generated by an electron cyclotron resonance plasma source with dual extraction grids and reactive species such as Cl₂ and/or BCl₃. The independent control of ion energy, ion density, flux of the reactive species, incident angle and substrate temperature enables a wide range of etch rates and etch profiles. Etch rates are typically highly uniform over large areas.

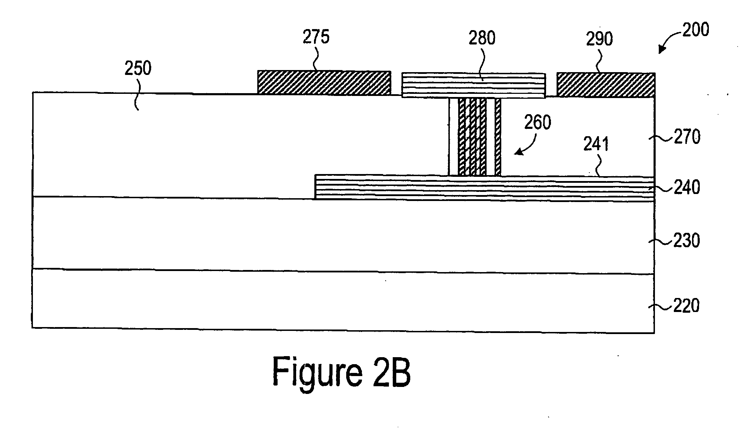

DBR 280 is then deposited over p-type AlGaN/GaN region 270. Possible materials for DBR 280 include alternating oxide layers of SiO₂/HfO₂ or ZrO₂/SiO₂. After DBR 280 is deposited it is patterned with photoresist and the exposed portions are etched away to yield DBR 280 as shown in FIG. 2b. Then n-type contact 275 and p-type contact 290 are deposited as shown in FIG. 2b resulting in VCSEL structure 200.

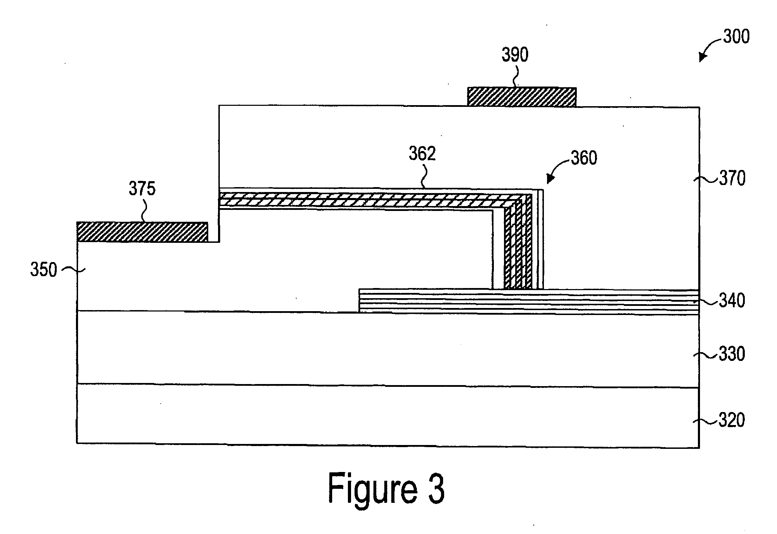

Embodiments in accordance with the invention include edge emitting lasers. FIG. 3 shows edge emitting laser structure 300 in accordance with the invention. Fabrication of edge emitting laser structure 300 differs from VCSEL structure 100 in part in that no DBRs are created. Instead at the stage where the first DBR is constructed for VCSEL structure 100, dielectric ELOG mask layer 340 is deposited over optional GaN buffer layer or over Al₂O₃ substrate 320 to a sufficient thickness, typically about 100 nm to avoid pinholes, and then patterned. After dielectric ELOG mask layer 340, typically using SiO₂, ELOG growth of n-type AIGaN/GaN region 350 is initiated. Note that vertical growth does not occur over the top of dielectric ELOG mask layer 340, growth is lateral. When ELOG growth of n-type AlGaN /GaN region 350 occurs over dielectric ELOG mask layer 340, the laterally growing deposition fronts are typically smooth and vertical. When n-type AlGaN/GaN region 350 has grown sufficiently over dielectric ELOG mask layer 340 for the crystal sidewalls to have developed, ELOG growth conditions are modified by lowering the reactor temperature to grow InGaN/InGaN multiple quantum well region 360. Note the sample remains in the MOVCD reactor throughout the ELOG growth allowing a single ELOG-MOCVD growth step. Hence, regrowth is avoided.

After growth of InGaN/InGaN multiple quantum well region 360, ELOG growth conditions are modified by increasing the reactor temperature to grow p-type AIGaN/GaN region 370 and growth is maintained until about 0.5 µm to about 10 µm of lateral growth from InGaN/GaN multiple quantum well region 360 has occurred to form a cladding layer. To allow deposition of n-contact 375, typically Ti-Au, a portion of p-type AIGaN/GaN region 370, a portion of horizontal part 362 of multiple quantum well region 160 and a portion of n-type AlGaN/GaN region 350 are etched away using, for example, chemically assisted ion beam etching (CAIBE). Then n-type contact 375 and p-type contact 390 are deposited resulting in edge emitting laser structure 300 in FIG. 3 in accordance with the invention. The surface area available for p-contact 390 in structure 300 is considerably larger by about a factor often than that typically available for conventional ridge waveguide edge emitting lasers, thereby minimizing contact resistance and allowing more current to be injected into the laser.

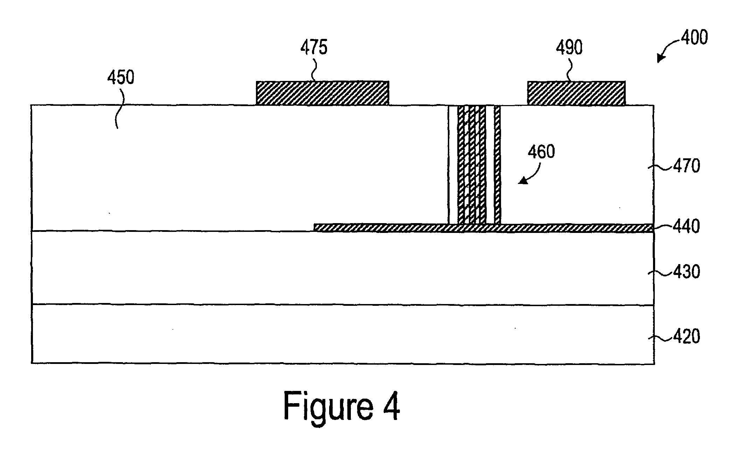

FIG. 4 shows edge emitting laser structure 400 in accordance with the invention. Differences between edge emitting laser structure 300 and edge emitting laser structure 400 involve the removal of overlying portion of p-type AIGaN/GaN region 370 and horizontal part 362 of multiple quantum well region 360 resulting in edge emitting laser structure 400 with multiple quantum well region 460. Removal of horizontal part 362 of multiple quantum well region 360 and overlying portion of p-type AlGaN/GaN region 370 to make edge emitting laser structure 400 is similar to the procedure described above for removal of horizontal part 262 of multiple quantum well region 260 of VCSEL structure 200 shown in FIG. 2b. This reduces parasitic effects and allows for n-type contact 475 and p-type contact 490 to be coplanar. Edge emitting laser structure 400 also includes p-type AlGaN/GaN region 470, n-type AlGaN/GaN region 450, Al₂O₃ substrate 420, dielectric ELOG mask layer 440 and optional GaN buffer layer 430.

While the invention has been described in conjunction with specific embodiments, it is evident to those skilled in the art that many alternatives, modifications, and variations will be apparent in light of the foregoing description. Accordingly, the invention is intended to embrace all other such alternatives, modifications, and variations that fall within the spirit and scope of the appended claims.

## Claims

1. A method for making a single ELOG growth transverse p-n junction nitride semiconductor laser comprising:
depositing and patterning a dielectric layer over a substrate; and
growing an ELOG region in a single growth step over said substrate, said ELOG region comprising an InGaN/InGaN multiple quantum well region positioned between an n-type and a p-type region, a first portion of said InGaN/InGaN multiple quantum well region oriented substantially nonparallel to said substrate.

2. The method of Claim 1 further comprising growing a GaN layer on said substrate.

3. The method of Claim 1 wherein said semiconductor laser is a VCSEL.

4. The method of Claim 2 further comprising depositing and patterning a DBR mirror on said GaN buffer layer.

5. The method of Claim 1 further comprising removing a second portion of said an InGaN/InGaN multiple quantum well region substantially perpendicular to said first portion of said InGaN/InGaN multiple quantum well region by an etching procedure.

6. The method of Claim I wherein a p-contact is disposed over said ELOG region.

7. The method of Claim 1 wherein said dielectric layer is an SiO₂ mask.

8. The method of Claim 4 wherein said DBR mirror comprises SiO₂ and HfO₂.

9. The method of Claim 1 further comprising etching at least one trench into said ELOG region to provide optical and carrier confinement.

10. The method of Claim 5 wherein said etching procedure is CAIBE.

11. A semiconductor laser structure comprising:
a substrate;
a dielectric layer disposed over a portion of said substrate; and
an ELOG region overlying said substrate, said ELOG region comprising an InGaN/InGaN multiple quantum well region positioned between an n-type and
a p-type region such that at least a portion of said InGaN/InGaN multiple quantum well region is oriented substantially nonparallel to said substrate.

12. The structure of Claim 11 further comprising a GaN buffer layer on said substrate.

13. The structure of Claim 11 wherein said semiconductor laser is a VCSEL.

14. The structure of Claim 11 further comprising a DBR mirror disposed over said substrate.

15. The structure of Claim 11 wherein said dielectric layer is an SiO₂ mask.

16. The structure of Claim 13 wherein said DBR mirror comprises SiO₂ and HfO₂.

17. The structure of Claim 11 further comprising at least one trench in said ELOG region.

18. The structure of Claim 11 further comprising a p-contact disposed on said ELOG region.

19. The structure of Claim 11 further comprising an n-contact substantially coplanar with said p-contact.

20. The structure of Claim 17 wherein said n-contact is comprised of Ti-Au.

21. The structure of Claim 10 wherein said dielectric layer has a thickness on the order of about 1000 angstrom.
